# FASCICULE DE BREVET EUROPEEN

(11) **EP 3 007 015 B1**
(45) Date de publication et mention de la délivrance du brevet: **31.01.2018**
(21) Numéro de dépôt: 15177931.1
(22) Date de dépôt: 22.07.2015
(51) Int. Cl.: G04C 10/02, G02F 1/1335, H05B 33/00

(54) **ENSEMBLE D'AFFICHAGE HYBRIDE COMPRENANT UNE CELLULE SOLAIRE**
HYBRIDANZEIGEEINHEIT, DIE EINE SOLARZELLE UMFASST
HYBRID DISPLAY ASSEMBLY INCLUDING A SOLAR CELL

(30) Priorité: 10.10.2014 EP 14188413
(43) Date de publication de la demande: 13.04.2016
(73) Titulaire: The Swatch Group Research and Development Ltd., 2074 Marin (CH)
(72) Inventeur: Sagardoyburu, Michel, 2000 Neuchâtel (CH)
(74) Mandataire: Supper, Marc

(56) Documents cités:
- EP-A1- 0 927 917
- EP-A1- 1 004 924
- JP-A- 2003 098 984
- JP-A- 2006 276 089
- US-B1- 6 229 767

## Description

### Domaine de l'invention

La présente invention concerne un ensemble d'affichage hybride comprenant une cellule solaire. Plus précisément, la présente invention concerne un tel ensemble d'affichage comprenant deux dispositifs d'affichage superposés sous lesquels est disposée une cellule solaire.

### Arrière-plan technologique de l'invention

La lisibilité des informations affichées par les dispositifs d'affichage tels que les cellules d'affichage à cristaux liquides ou bien les dispositifs d'affichage à diodes organiques électroluminescentes est très dépendante des conditions de luminosité ambiante. Avec certains dispositifs d'affichage, les informations affichées peuvent être lues dans de bonnes conditions dans un environnement éclairé, mais par contre sont difficiles à lire dans un environnement sombre. Inversement, d'autres catégories de dispositifs d'affichage fournissent un affichage de bonne qualité dans la pénombre ou l'obscurité, mais sont difficilement lisibles en plein jour.

A titre d'exemple, considérons les cellules d'affichage à cristal liquide de type transflectif, c'est-à-dire des cellules d'affichage à cristal liquide capables d'afficher des informations qui vont être visibles de jour grâce à un phénomène de réflexion, et qui vont être également visibles dans le noir par transmission en utilisant un dispositif de rétroéclairage. De telles cellules d'affichage à cristal liquide de type transflectif sont optimisées pour pouvoir réfléchir au mieux la lumière du soleil et ainsi garantir une bonne lisibilité des informations affichées dans des conditions de forte luminosité ambiante. Cependant, afin que de telles cellules d'affichage à cristal liquide de type transflectif puissent réfléchir au mieux la lumière du soleil, leur efficacité en transmission est fortement limitée. Ainsi, lorsque le dispositif de rétroéclairage est activé afin de permettre de lire les informations affichées dans la pénombre, une majeure partie de la lumière émise par le dispositif de rétroéclairage se perd dans des phénomènes d'absorption. Le rendement énergétique est donc médiocre. En outre, les qualités optiques des informations affichées par la cellule à cristal liquide sont fortement dépendantes de l'angle de vue.

En ce qui concerne les dispositifs d'affichage de type émissif tels que les dispositifs d'affichage à diodes organiques électroluminescentes, ils présentent des qualités optiques qui sont supérieures à celles des cellules d'affichage à cristal liquide, ces qualités optiques ne dépendant notamment pas de l'angle de vue. Néanmoins, ces dispositifs d'affichage de type émissif de haute qualité ne permettent pas un fonctionnement en mode réflectif. Les informations qu'ils affichent sont donc très lisibles dans la pénombre ou l'obscurité, mais deviennent difficilement lisibles dès qu'elles sont observées en extérieur. Pour remédier à ce problème, il est possible d'augmenter la quantité de courant fournie aux dispositifs d'affichage émissifs afin d'accroître la brillance des diodes électroluminescentes et ainsi garantir un minimum de lisibilité. Toutefois, même en conditions d'utilisation normale, ces dispositifs d'affichage émissifs consomment davantage qu'une cellule à cristal liquide de type réflectif. Leur consommation électrique est telle qu'il est difficilement envisageable de les conserver allumés en permanence, en particulier lorsqu'ils sont embarqués dans un objet portable de petites dimensions tels qu'une montre-bracelet dont la seule source d'énergie est une pile dont on souhaite habituellement qu'elle dure au moins un an.

### Résumé de l'invention

La présente invention a pour but de remédier aux problèmes susmentionnés ainsi qu'à d'autres encore en procurant un ensemble d'affichage dont les besoins en énergie peuvent être satisfaits même lorsqu'il est embarqué dans un objet portable de petites dimensions tel qu'une montre-bracelet dont les réserves en énergie sont pourtant limitées. La présente invention procure également un ensemble d'affichage dont le fonctionnement est satisfaisant aussi bien dans un environnement fortement éclairé que dans un environnement sombre.

A cet effet, la présente invention concerne un ensemble d'affichage pour un objet portable, tel que décrit dans la revendication 1. Grâce à ces caractéristiques, la présente invention procure un ensemble d'affichage pour un objet portable tel qu'une montre-bracelet dont le fonctionnement est optimal quelles que soient les conditions d'éclairement ambiant. En plein jour, les informations seront préférentiellement affichées par le dispositif d'affichage réflectif. En effet, ce dispositif d'affichage réflectif, mettant à profit un phénomène de réflexion de la lumière du soleil pour afficher les informations, est économe en énergie. Il peut donc rester allumé en permanence et offre une bonne lisibilité des informations. Inversement, dans la pénombre ou l'obscurité, les informations seront affichées par le dispositif d'affichage émissif. Un tel dispositif d'affichage émissif consomme davantage de courant qu'un dispositif d'affichage réflectif, mais les informations qu'il affiche sont visibles de nuit ou dans l'obscurité avec de très bonnes propriétés optiques qui sont notamment indépendantes de l'angle de vue. De plus, si ce type de dispositif d'affichage émissif est principalement utilisé de nuit ou dans des environnements faiblement éclairés, sa consommation de courant électrique reste néanmoins limitée car il n'est pas nécessaire, dans de telles conditions, de l'alimenter à pleine puissance. Au contraire, une faible puissance électrique est déjà suffisante pour permettre une lecture aisée des informations. Ainsi, à la différence d'une cellule d'affichage à cristal liquide de type transflectif qui cherche à parvenir à un compromis entre la réflectivité de son mode réflectif, et la consommation d'énergie électrique de son dispositif de rétroéclairage en mode transmissif, l'ensemble d'affichage selon l'invention propose de combiner deux dispositifs d'affichage, l'un purement réflectif et l'autre purement émissif, sans compromettre les performances ni de l'un, ni de l'autre de ces deux dispositifs d'affichage. En outre, en enseignant de disposer une cellule solaire sous les deux dispositifs d'affichage superposés, la présente invention permet l'intégration d'un tel ensemble dans un objet portable de petites dimensions dont les réserves en énergie électrique sont nécessairement limitées. En effet, on a constaté que la quantité de lumière qui parvenait à la cellule solaire à travers l'ensemble des deux dispositifs d'affichage superposés était suffisante pour fournir, par phénomène de conversion photoélectrique, la quantité d'énergie électrique nécessaire au fonctionnement des deux dispositifs d'affichage superposés. Par conséquent, les réserves d'énergie électrique de l'objet portable sont peu, ou pas sollicitées par le fonctionnement des deux dispositifs d'affichage superposés.

Selon un mode de réalisation de l'invention, le premier dispositif d'affichage comprend une cellule d'affichage émissive transparente, et le second dispositif d'affichage comprend une cellule d'affichage à cristal liquide réflective de type nématique en hélice ou super-nématique en hélice ou bien encore à alignement vertical. La cellule d'affichage émissive transparente est au choix une cellule d'affichage émissive transparente à diodes organiques électroluminescentes ou une cellule d'affichage émissive transparente inorganique.

Selon une caractéristique complémentaire de l'invention, la cellule d'affichage à diodes organiques électroluminescentes est disposée entre un polariseur circulaire et une lame quart d'onde, le polariseur circulaire étant placé du côté de l'observateur.

L'adressage des zones électroluminescentes des cellules d'affichage à diodes organiques électroluminescentes est assuré par des électrodes transparentes le plus souvent réalisées à l'aide d'un matériau métallique ou d'un oxyde métallique. Ces électrodes provoquent donc assez souvent de légers phénomènes de réflexion optique qui induisent une dégradation du contraste, ce qui nuit à la lisibilité des informations affichées par les cellules d'affichage à diodes organiques électroluminescentes. Pour remédier à cet inconvénient, la présente invention enseigne de disposer la cellule d'affichage à diodes organiques électroluminescentes entre un polariseur circulaire et une lame quart d'onde, le polariseur circulaire étant placé du côté de l'observateur. Ainsi, une des composantes de polarisation de la lumière ambiante qui pénètre dans l'ensemble d'affichage selon l'invention est absorbée par le polariseur circulaire, tandis que l'autre composante de polarisation de la lumière est polarisée circulairement. Lorsqu'en traversant la cellule d'affichage à diodes organiques électroluminescentes, la lumière ambiante polarisée circulairement est partiellement réfléchie par les électrodes transparentes de la cellule d'affichage à diodes organiques électroluminescentes, cette lumière réfléchie subit un déphasage, ce qui a pour effet de transformer sa polarisation circulaire en polarisation circulaire de sens de rotation opposé. Ainsi, lorsque la lumière réfléchie traverse à nouveau le polariseur circulaire, elle est absorbée par ce dernier. De cette manière, il est possible d'éliminer la lumière parasite qui se réfléchit sur les électrodes de la cellule d'affichage à diodes organiques électroluminescentes, et de ne conserver que la lumière qui traverse la cellule d'affichage à diodes organiques électroluminescentes sans modification. Par suite, la lumière se retrouve à nouveau polarisée linéairement après son passage à travers la lame quart d'onde placée sous la cellule d'affichage à diodes organiques électroluminescentes et sera finalement absorbée ou réfléchie par la cellule d'affichage à cristal liquide réflective selon que l'on recherche un affichage à contraste positif ou négatif.

### Brève description des figures

D'autres caractéristiques et avantages de la présente invention ressortiront plus clairement de la description détaillée qui suit d'un mode de réalisation de l'ensemble d'affichage selon l'invention, cet exemple étant donné à titre purement illustratif et non limitatif seulement en liaison avec le dessin annexé sur lequel :

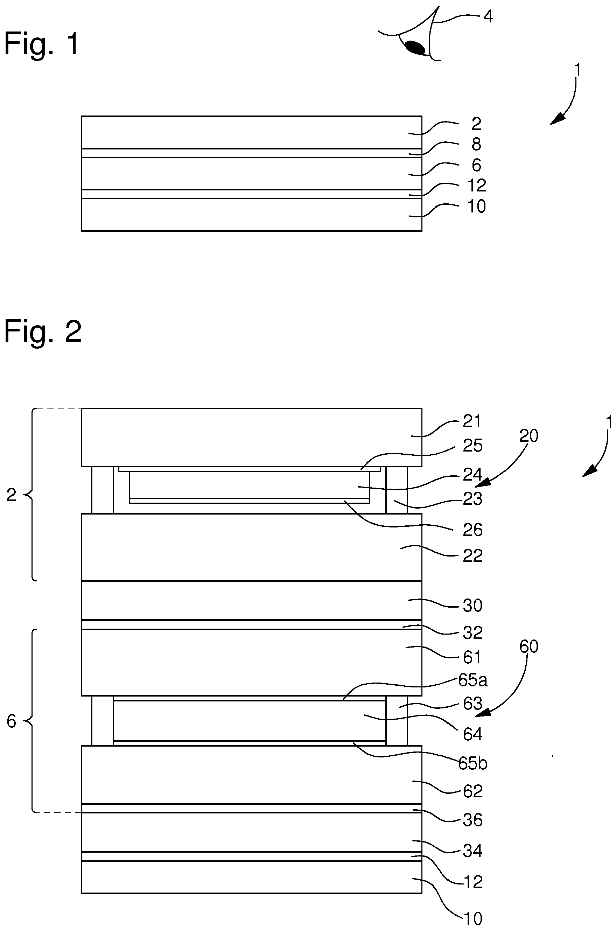

- la figure 1 est une vue schématique en coupe illustrant un ensemble d'affichage selon l'invention comprenant un premier dispositif d'affichage émissif au moins partiellement transparent situé du côté d'un observateur, un second dispositif d'affichage réflectif et une cellule solaire étant disposés dans cet ordre sous le premier dispositif d'affichage émissif ;
- la figure 2 est une vue en coupe d'un exemple de réalisation d'un ensemble d'affichage selon l'invention dans lequel le premier dispositif d'affichage est une cellule d'affichage émissive transparente à diodes organiques électroluminescentes, et le second dispositif d'affichage est une cellule d'affichage à cristal liquide réflective de type nématique en hélice, une cellule solaire étant disposée sous cet ensemble d'affichage ;

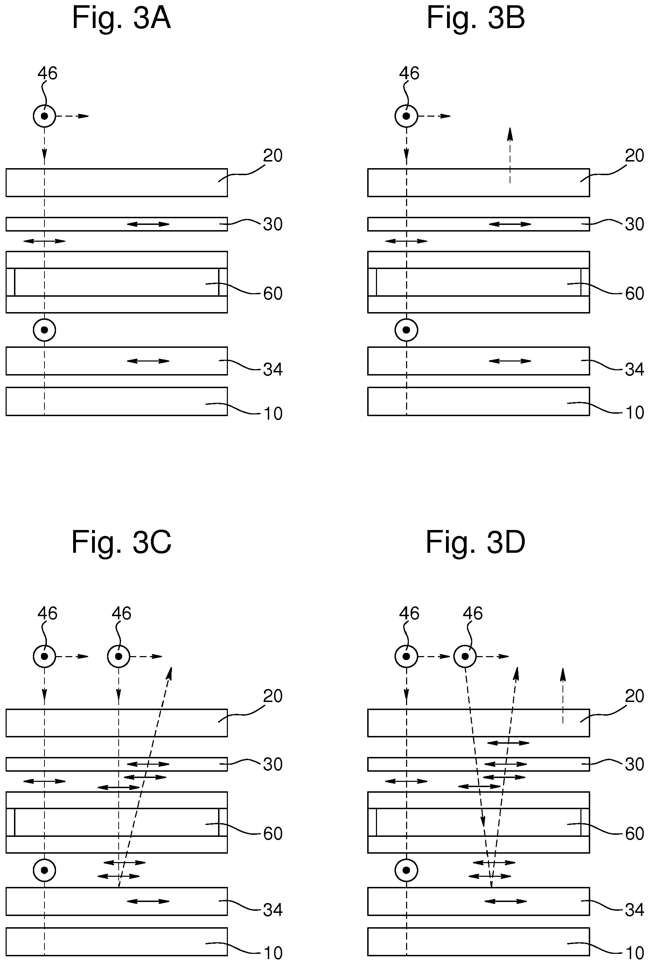

- les figures 3A à 3D illustrent schématiquement le mode de fonctionnement de l'ensemble d'affichage illustré à la figure 2 selon que la cellule d'affichage à diodes organiques électroluminescentes et la cellule d'affichage à cristal liquide nématique en hélice sont actives ou passives ;

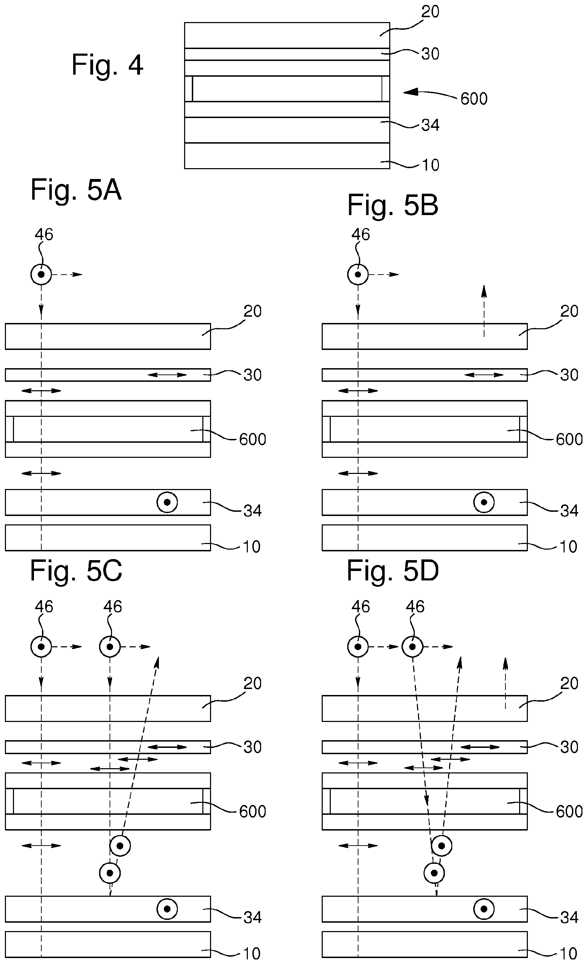

- la figure 4 est une vue similaire à celle de la figure 2 dans laquelle le second dispositif d'affichage est une cellule d'affichage à cristal liquide réflective à alignement vertical ;
- les figures 5A à 5D illustrent schématiquement le mode de fonctionnement de l'ensemble d'affichage illustré à la figure 4 selon que la cellule d'affichage à diodes organiques électroluminescentes et la cellule d'affichage à cristal liquide aligné verticalement sont actives ou passives, et

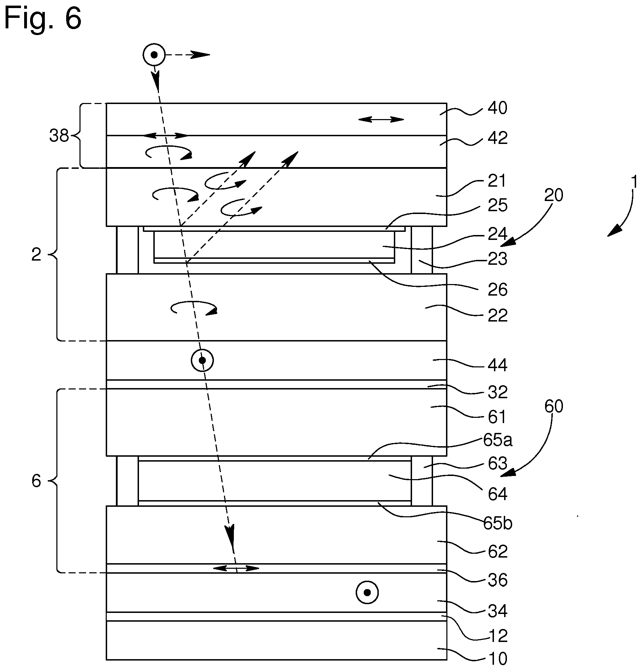

- la figure 6 est une vue similaire à celle de la figure 2 à ceci près que, dans le but de supprimer les réflexions parasites et d'améliorer ainsi le contraste d'affichage, on place au-dessus de la cellule d'affichage transparente à diodes organiques électroluminescentes, du côté de l'observateur, un polariseur circulaire qui se compose d'un second polariseur absorbant et d'une première lame quart d'onde.

### Description détaillée d'un mode de réalisation de l'invention

La présente invention procède de l'idée générale inventive qui consiste à procurer un ensemble d'affichage qui soit capable d'afficher de manière lisible des informations à la fois en plein jour et dans la pénombre ou l'obscurité et dont la consommation d'énergie électrique soit optimale. Pour atteindre cet objectif, la présente invention enseigne de combiner un dispositif d'affichage de type émissif avec un dispositif d'affichage qui est agencé pour pouvoir commuter entre un état de repos dans lequel il est transparent et un état actif dans lequel il est capable de réfléchir la lumière ambiante. Le dispositif d'affichage de type émissif est typiquement une cellule d'affichage à diodes organiques électroluminescentes, tandis que le dispositif d'affichage de type réflectif est typiquement une cellule d'affichage à cristal liquide. Pour l'affichage des informations en plein jour, on privilégie l'utilisation du dispositif d'affichage de type réflectif qui, par réflexion de la lumière du soleil, permet d'afficher les informations de manière claire et lisible tout en consommant peu d'énergie électrique. Pour l'affichage des informations dans la pénombre ou l'obscurité, on privilégie l'utilisation du dispositif d'affichage émissif. Grâce à ses excellentes propriétés optiques, notamment en termes de contraste et de reproduction des couleurs, un tel dispositif d'affichage émissif permet d'afficher un grand nombre d'informations de manière très lisible. En particulier, la lisibilité des informations affichées n'est pas dépendante de l'angle de vue. De plus, dans la pénombre ou l'obscurité, il est possible de réduire de manière significative la consommation d'énergie d'un tel dispositif d'affichage émissif tout en garantissant une bonne lisibilité des informations affichées. On dispose ainsi d'un ensemble d'affichage qui comprend un dispositif d'affichage réflectif placé à la base de l'empilement et qui est capable d'afficher des informations en permanence en consommant très peu d'énergie, et un dispositif d'affichage émissif placé sur le dessus de l'empilement et qui est capable d'afficher à la demande des informations de manière très lisible dans la pénombre ou l'obscurité. On s'est rendu compte en outre qu'en disposant une cellule solaire sous les deux dispositifs d'affichage superposés, la cellule solaire produisait, par effet de conversion photoélectrique, un courant électrique suffisant pour permettre le fonctionnement des deux dispositifs d'affichage superposés. Il est donc possible d'intégrer un tel ensemble d'affichage dans un objet portable de petites dimensions tel qu'une montre-bracelet dont les capacités de stockage en énergie électrique sont pourtant limitées.

La figure 1 est une vue schématique en coupe d'un ensemble d'affichage selon l'invention. Désigné dans son ensemble par la référence numérique générale 1, cet ensemble d'affichage comprend un premier dispositif d'affichage émissif 2 au moins partiellement transparent disposé du côté d'un observateur 4, et un second dispositif d'affichage réflectif 6 lui aussi au moins partiellement transparent disposé sous le premier dispositif d'affichage émissif 2. Au sens de la présente invention, le premier dispositif d'affichage émissif 2 est capable de commuter entre un état passif dans lequel il est au moins partiellement transparent, et un état actif dans lequel il émet de la lumière pour afficher une information. Quant au second dispositif d'affichage réflectif 6, il est capable de commuter entre un état passif dans lequel il est transparent et un état actif dans lequel il est capable de réfléchir la lumière ambiante

De préférence mais non impérativement, le premier dispositif d'affichage émissif 2 est solidarisé sur le second dispositif d'affichage réflectif 6 au moyen d'une couche adhésive transparente 8. Cette couche adhésive transparente 8 peut être formée d'un adhésif en film ou d'une couche de colle liquide acrylique ou silicone. Cette couche adhésive transparente 8 a pour objet d'éviter les problèmes de réflexions parasites qui surviendraient si les deux dispositifs d'affichage 2, 6 étaient séparés par une couche d'air et qui dégraderaient la qualité optique de l'ensemble d'affichage 1 selon l'invention.

Enfin, une cellule solaire 10 capable de fournir de l'énergie électrique en exploitant le phénomène de conversion photoélectrique est disposée sous le second dispositif d'affichage réflectif 6. A titre préféré mais non limitatif, la cellule solaire 10 est collée sous le second dispositif d'affichage réflectif 6 au moyen d'une couche adhésive transparente 12.

Dans tout ce qui suit, l'invention sera décrite en référence à une cellule d'affichage émissive transparente du type à diodes organiques électroluminescentes. On comprendra néanmoins que cet exemple est donné à titre purement illustratif et non limitatif seulement et que d'autres types de cellules d'affichage émissive transparentes tels que des cellules d'affichage émissives transparentes inorganiques encore connues sous leur dénomination anglo-saxonne Electro Luminescent Display ou ELD peuvent être envisagés sans sortir des limites de l'invention telles que définies par les revendications annexées.

La figure 2 est une vue en coupe détaillée d'un exemple de réalisation de l'ensemble d'affichage 1 selon l'invention dans le cas où le premier dispositif d'affichage émissif 2 comprend une cellule d'affichage émissive transparente 20 à diodes organiques électroluminescentes qui sera désignée dans tout ce qui suit par cellule d'affichage transparente TOLED (Transparent Organic Light Emitting Diode). Quant au second dispositif d'affichage réflectif 6, il comprend une cellule d'affichage à cristal liquide réflective 60 de type nématique en hélice, également connue sous sa dénomination anglo-saxonne Twist Nematic ou TN.

Plus précisément, la cellule d'affichage transparente TOLED 20 comprend un substrat transparent 21 réalisé en verre ou en un matériau plastique et un capot d'encapsulation 22 qui s'étend parallèlement à et à distance du substrat transparent 21. Le substrat transparent 21 et le capot d'encapsulation 22 sont réunis entre eux par un cadre de scellement 23 qui délimite un volume clos à l'abri de l'air et de l'humidité pour le confinement d'un empilement de couches électroluminescentes généralement désigné par la référence numérique 24. Une électrode supérieure transparente 25 réalisée par exemple en oxyde d'étain-indium ou ITO et une électrode inférieure transparente 26 réalisée par exemple au moyen d'un matériau métallique tel que l'aluminium ou l'argent ou d'un oxyde métallique tel que l'ITO ou l'oxyde de zinc-indium sont structurées de part et d'autre de l'empilement des couches électroluminescentes 24. Ces électrodes 25, 26, réalisées en un matériau métallique, sont légèrement réfléchissantes. Les cellules d'affichage transparentes à diodes organiques électroluminescentes sont disponibles soit avec un adressage direct dans les cas où il s'agit simplement d'afficher des icônes ou des segments, soit avec un adressage du type à matrice passive dans le cas d'un affichage matriciel à points. Dans le cas d'un affichage à matrice de points, on peut également avoir affaire à un adressage du type à matrice active combiné avec des transistors transparents du type Thin Film Transistor ou TFT destinés à contrôler le courant et qui sont ménagés dans les pixels d'affichage.

D'autre part, la cellule d'affichage à cristal liquide réflective 60 comprend un substrat avant 61 disposé du côté de l'observateur 4 et un substrat arrière 62 qui s'étend parallèlement à et à distance du substrat avant 61. Les substrats avant 61 et arrière 62 sont réunis entre eux par un cadre de scellement 63 qui délimite une enceinte étanche 64 pour le confinement d'un cristal liquide dont les propriétés optiques sont modifiées par application d'une tension appropriée à un point de croisement considéré entre des électrodes transparentes 65a ménagées sur une face inférieure du substrat avant 61 et des contre-électrodes transparentes 65b ménagées sur une face supérieure de substrat arrière 62. Les électrodes 65a et les contre-électrodes 65b sont réalisées en un matériau transparent électriquement conducteur tel que de l'oxyde d'indium-zinc ou de l'oxyde d'indium-étain, ce dernier matériau étant mieux connu sous sa dénomination anglo-saxonne Indium Tin Oxyde ou ITO.

Dans le cas de la présente invention, toutes les phases des cristaux liquides telles que nématique en hélice (Twist Nematic ou TN en terminologie anglo-saxonne), super-nématique en hélice (Super Twist Nematic ou STN en terminologie anglo-saxonne) ou bien encore à alignement vertical (Vertically Aligned ou VA en terminologie anglo-saxonne) peuvent être envisagées. De même, tous les types d'adressage tels qu'adressage direct, adressage par matrice active ou adressage multiplexé d'une matrice passive peuvent être envisagés.

Un polariseur absorbant 30 est collé sur une face supérieure du substrat avant 61 de la cellule d'affichage à cristal liquide réflective 60 au moyen d'une couche adhésive 32. Cette couche adhésive 32 peut être formée d'un adhésif en film ou d'une couche de colle liquide. La colle utilisée pour solidariser le polariseur absorbant 30 sur la cellule d'affichage à cristal liquide réflective 60 peut-être transparente ou légèrement diffusante selon que l'on cherche à obtenir une réflexion spéculaire ou bien diffuse. Quant au polariseur absorbant 30, il peut être, par exemple, du type à iodine ou à colorant.

Un polariseur réflectif absorbant 34 est collé sur une face inférieure du substrat arrière 62 de la cellule d'affichage à cristal liquide réflective 60 au moyen d'une couche adhésive 36 qui peut être transparente ou légèrement diffusante selon que l'on cherche à obtenir une réflexion spéculaire ou bien diffuse.

On examine maintenant en liaison avec les figures 3A à 3D les principes de fonctionnement de l'ensemble d'affichage 1 selon l'invention selon que la cellule d'affichage transparente TOLED 20 et la cellule d'affichage à cristal liquide réflective 60 sont en service ou non. On supposera, à titre d'exemple purement illustratif et nullement limitatif seulement, que la cellule d'affichage à cristal liquide réflective 60 est une cellule à cristal liquide nématique en hélice TN et que l'axe de transmission du polariseur absorbant 30 et l'axe de réflexion du polariseur réflectif 34 sont parallèles.

A la figure 3A, la cellule d'affichage transparente TOLED 20 et la cellule d'affichage à cristal liquide réflective TN 60 sont toutes les deux éteintes. La lumière ambiante, désignée par la référence numérique 46, traverse sans modification la cellule d'affichage transparente TOLED 20, puis est polarisée linéairement par le polariseur absorbant 30. La lumière ambiante 46 subit ensuite une rotation de 90° lorsqu'elle traverse la cellule d'affichage à cristal liquide réflective TN 60, de sorte que lorsqu'elle tombe sur le polariseur réflectif 34, sa direction de polarisation est perpendiculaire à l'axe de réflexion du polariseur réflectif 34 et elle traverse donc ce dernier avant d'être absorbée par la cellule solaire 10. La cellule d'affichage à cristal liquide réflective TN 60 apparaît donc sombre lorsqu'elle est éteinte, ce qui signifie que les informations qu'elle va afficher vont apparaître en clair sur un fond sombre. L'affichage des informations est donc à contraste négatif. Bien entendu, un affichage des informations selon un contraste positif pourrait être obtenu simplement en veillant à ce que l'axe de transmission du polariseur 30 et l'axe de réflexion du polariseur réflectif absorbant 34 soient perpendiculaires. Dans ce cas, la lumière ambiante 46 atteint la cellule solaire seulement dans les zones de la cellule d'affichage à cristal liquide réflective TN 60 qui sont commutées.

A la figure 3B, la cellule d'affichage transparente TOLED 20 est activée, tandis que la cellule d'affichage à cristal liquide réflective TN 60 est désactivée. La lumière émise par la cellule d'affichage transparente TOLED 20 parvient à l'observateur 4 sans modification, tandis que la cellule d'affichage à cristal liquide réflective TN 60 apparaît sombre. Les informations affichées par la cellule d'affichage transparente TOLED 20 se détachent donc sur un fond sombre.

A la figure 3C, la cellule d'affichage transparente TOLED 20 est éteinte, tandis que la cellule d'affichage à cristal liquide réflective TN 60 est activée. Comme déjà expliqué ci-dessus, les zones non commutées de la cellule d'affichage à cristal liquide réflective TN 60 apparaissent sombres. Par contre, dans les zones commutées de la cellule d'affichage à cristal liquide réflective TN 60, la lumière ambiante 46 traverse ces zones sans modification, de sorte que la lumière ambiante 46 tombe sur le polariseur réflectif 34 avec une direction de polarisation parallèle à l'axe de réflexion de ce polariseur réflectif 34. La lumière ambiante 46 est donc réfléchie en arrière et traverse successivement la cellule d'affichage à cristal liquide réflective TN 60, le polariseur absorbant 30 et la cellule d'affichage transparente TOLED 20 sans modification, de sorte qu'elle est perceptible par l'observateur 4. Les informations s'affichent donc en clair sur un fond sombre.

A la figure 3D, la cellule d'affichage transparente TOLED 20 et la cellule d'affichage à cristal liquide réflective TN 60 sont toutes deux activées. La lumière émise par la cellule d'affichage transparente TOLED 20 est directement perceptible par l'observateur 4. La lumière ambiante 46 qui traverse les zones non commutées de la cellule d'affichage à cristal liquide réflective TN 60 est absorbée par la cellule solaire 10, de sorte que ces zones apparaissent sombres. Enfin, la lumière ambiante 46 qui traverse les zones commutées de la cellule d'affichage à cristal liquide réflective TN 60 est réfléchie par le polariseur réflectif 34, de sorte que ces zones apparaissent claires.

La figure 4 est une vue en coupe d'un exemple de réalisation de l'ensemble d'affichage 1 selon l'invention dans le cas où le premier dispositif d'affichage 2 comprend une cellule d'affichage émissive transparente 20 à diodes organiques électroluminescentes qui sera désignée dans tout ce qui suit par cellule d'affichage transparente TOLED (Transparent Organic Light Emitting Diode). Quant au second dispositif d'affichage 6, il comprend une cellule d'affichage à cristal liquide réflective 600 à alignement vertical, également connue sous sa dénomination anglo-saxonne Vertically Aligned ou VA.

On examine maintenant en liaison avec les figures 5A à 5D les principes de fonctionnement de l'ensemble d'affichage 1 selon l'invention selon que la cellule d'affichage transparente TOLED 20 et la cellule d'affichage à cristal liquide réflective VA 600 sont en service ou non. On supposera, à titre d'exemple purement illustratif et nullement limitatif seulement, que l'axe de transmission du polariseur absorbant 30 et l'axe de réflexion du polariseur réflectif 34 sont perpendiculaires.

A la figure 5A, la cellule d'affichage transparente TOLED 20 et la cellule d'affichage à cristal liquide réflective VA 600 sont toutes les deux éteintes. La lumière ambiante, désignée par la référence numérique 46, traverse successivement sans modification la cellule d'affichage transparente TOLED 20 et la cellule d'affichage à cristal liquide réflective VA 600, de sorte que lorsqu'elle tombe sur le polariseur réflectif 34, sa direction de polarisation est perpendiculaire à l'axe de réflexion du polariseur réflectif 34. Elle traverse donc ce dernier sans modification et est finalement absorbée par la cellule solaire 10. La cellule d'affichage à cristal liquide réflective VA 600 apparaît donc sombre lorsqu'elle est éteinte, ce qui signifie que les informations qu'elle va afficher vont apparaître en clair sur un fond sombre. L'affichage des informations est donc à contraste négatif. Bien entendu, un affichage des informations selon un contraste positif peut être obtenu simplement en veillant à ce que l'axe de transmission du polariseur absorbant 30 et l'axe de réflexion du polariseur réflectif34 soient parallèles.

A la figure 5B, la cellule d'affichage transparente TOLED 20 est activée, tandis que la cellule d'affichage à cristal liquide réflective VA 600 est désactivée. La lumière émise par la cellule d'affichage transparente TOLED 20 parvient à l'observateur 4 sans modification, tandis que la cellule d'affichage à cristal liquide réflective VA 600 apparaît sombre. Les informations affichées par la cellule d'affichage transparente TOLED 20 se détachent donc sur un fond sombre.

A la figure 5C, la cellule d'affichage transparente TOLED 20 est éteinte, tandis que la cellule d'affichage à cristal liquide réflective VA 600 est activée.

Dans une cellule à cristal liquide à alignement vertical, les couches d'alignement sont orientées à 45° par rapport aux axes de polarisation des polariseurs. D'autre part, le résultat du produit entre la biréfringence des molécules de cristal liquide et la distance entre les substrats avant et arrière est choisi de façon que, lorsque le cristal liquide est commuté, il se comporte vis-à-vis de la direction de polarisation de la lumière comme une lame demi-onde. Par conséquent, comme cette lame demi-onde est placée à 45° par rapport à l'axe de polarisation du polariseur absorbant, elle provoque une rotation de 90° de la direction de polarisation de la lumière. Ainsi, la lumière ambiante 46 subit une rotation de 90° lorsqu'elle traverse les zones commutées de la cellule d'affichage à cristal liquide réflective VA 600, de sorte que lorsqu'elle tombe sur le polariseur réflectif 34, sa direction de polarisation est parallèle à l'axe de réflexion du polariseur réflectif 34 et elle est donc réfléchie par ce dernier. Quant à la lumière ambiante 46 qui traverse les zones non commutées de la cellule d'affichage à cristal liquide réflective VA 600, elle est absorbée par la cellule solaire 10. Les informations s'affichent donc en clair sur un fond sombre, c'est-à-dire avec un contraste négatif.

A la figure 5D, la cellule d'affichage transparente TOLED 20 et la cellule d'affichage à cristal liquide réflective VA 600 sont toutes deux activées. La lumière émise par la cellule d'affichage transparente TOLED 20 est directement perceptible par l'observateur 4. La lumière ambiante 46 qui traverse les zones non commutées de la cellule d'affichage à cristal liquide réflective VA 600 est absorbée par la cellule solaire 10, de sorte que ces zones apparaissent sombres. Enfin, la lumière ambiante 46 qui traverse les zones commutées de la cellule d'affichage à cristal liquide réflective VA 600 est réfléchie par le polariseur réflectif 34, de sorte que ces zones apparaissent claires.

La figure 6 est une vue similaire à celle de la figure 2 à ceci près que, dans le but de supprimer les réflexions parasites et d'améliorer ainsi le contraste d'affichage, on place au-dessus de la cellule d'affichage transparente TOLED 20, du côté de l'observateur 4, un polariseur circulaire 38 qui se compose d'un second polariseur absorbant 40 et d'une première lame quart d'onde 42. D'autre part, une seconde lame quart d'onde 44 est placée sous la cellule d'affichage transparente TOLED 20. Cette seconde lame quart d'onde 44 est parallèle à la première lame quart d'onde 42 ou bien disposée à 90° par rapport à la première lame quart d'onde 42. On supposera que l'axe de transmission du second polariseur absorbant 40 et l'axe de réflexion du polariseur réflectif 34 sont perpendiculaires.

L'adressage des zones électroluminescentes des cellules d'affichage à diodes organiques électroluminescentes est assuré par des électrodes transparentes le plus souvent réalisées à l'aide d'un matériau métallique ou d'un oxyde métallique. Ces électrodes provoquent donc assez souvent des phénomènes de réflexion optique qui induisent une dégradation du contraste, ce qui nuit à la lisibilité des informations affichées par les cellules d'affichage à diodes organiques électroluminescentes. Pour remédier à cet inconvénient, la présente invention enseigne de disposer un polariseur circulaire 38 au-dessus de la cellule d'affichage transparente TOLED 20 et une seconde lame quart d'onde 44 sous la cellule d'affichage transparente TOLED 20. Ainsi, la lumière ambiante 46 qui pénètre dans l'ensemble d'affichage 1 selon l'invention est polarisée linéairement par le second polariseur absorbant 40, puis polarisée circulairement par la première lame quart d'onde 42. Lorsqu'en traversant la cellule d'affichage transparente TOLED 20, la lumière ambiante 46 polarisée circulairement est partiellement réfléchie par les électrodes supérieure et inférieure transparentes 25, 26 de la cellule d'affichage transparente TOLED 20, cette lumière réfléchie subit un déphasage, ce qui a pour effet de transformer sa polarisation circulaire en polarisation circulaire de sens de rotation opposé. Ainsi, lorsque la lumière réfléchie traverse à nouveau le polariseur circulaire 38, elle est absorbée par ce dernier. De cette manière, il est possible d'éliminer la lumière parasite qui se réfléchit sur les électrodes 25, 26 de la cellule d'affichage transparente TOLED 20. La lumière ambiante 46 restante traverse sans modification la cellule d'affichage transparente TOLED 20, puis est polarisée linéairement lors de son passage à travers la seconde lame quart d'onde 44 selon une direction perpendiculaire à l'axe de transmission du second polariseur absorbant 40. On suppose en effet que les première et seconde lames quart d'onde 42 et 44 sont parallèles entre elles. Lors du passage de la lumière ambiante 46 à travers la cellule d'affichage à cristal liquide réflective 60, la direction de polarisation de la lumière ambiante 46 est tournée de 90°, de sorte qu'elle est finalement absorbée par la cellule solaire 10.

L'affichage se fait donc en clair sur un fond sombre. Autrement dit, l'ensemble d'affichage 1 est à contraste négatif. En effet, dans les zones commutées de la cellule d'affichage à cristal liquide réflective 60, la lumière ambiante 46 traverse la cellule d'affichage à cristal liquide réflective 60 sans modification, de sorte qu'elle tombe sur le polariseur réflectif 34 selon une direction de polarisation qui est parallèle à l'axe de réflexion de ce dernier. La lumière ambiante 46 est donc réfléchie par le polariseur réflectif 34, puis traverse la cellule d'affichage à cristal liquide réflective 60 sans modification. La lumière ambiante 46 est ensuite polarisée circulairement par la seconde lame quart d'onde 44, puis traverse sans modification le polariseur circulaire 38 et est perceptible par l'observateur 4.

A titre de variante, il est possible d'envisager de disposer la seconde lame quart d'onde 44 entre la cellule d'affichage à cristal liquide réflective 60 et le polariseur réflectif absorbant 34.

Il va de soi que la présente invention n'est pas limitée aux modes de réalisation qui viennent d'être décrits et que diverses modifications et variantes simples peuvent être envisagées par l'homme du métier sans sortir du cadre de l'invention tel que défini par les revendications annexées à la présente demande de brevet. On comprendra en particulier que dire que la lumière ambiante traverse sans modification la cellule d'affichage à cristal liquide réflective ou la cellule d'affichage transparente TOLED est quelque peu un abus de langage. En effet, lorsque la lumière ambiante traverse ces cellules d'affichage, il se produit toujours des phénomènes minimes de réflexion parasite de la lumière. Ces réflexions parasites sont néanmoins tout à fait négligeables dans le cadre de la présente invention. On aura également compris de ce qui a été dit ci-dessus que parler d'électrodes « transparentes » est également quelque peu un abus de langage. En effet, bien que réalisées en un matériau transparent électriquement conducteur, ces électrodes sont toujours très légèrement réfléchissantes. La cellule d'affichage à cristal liquide réflective est choisie dans le groupe formé par les cellules d'affichage à cristal liquide de type nématique en hélice, les cellules d'affichage à cristal liquide de type super nématique en hélice et les cellules d'affichage à cristal liquide de type à alignement vertical. La cellule d'affichage à cristal liquide réflective peut être une cellule d'affichage bistable.

### Nomenclature

Ensemble d'affichage 1
Premier dispositif d'affichage émissif 2
Observateur 4
Second dispositif d'affichage réflectif 6
Couche adhésive transparente 8
Cellule solaire 10
Couche adhésive transparente 12
Cellule d'affichage transparente TOLED 20
Substrat transparent 21
Capot d'encapsulation 22
Cadre de scellement 23
Empilement de couches électroluminescentes 24
Electrode supérieure transparente 25
Electrode inférieure transparente 26
Polariseur absorbant 30
Couche adhésive 32
Polariseur réflectif absorbant 34
Couche adhésive 36
Polariseur circulaire 38
Second polariseur absorbant 40
Première lame quart d'onde 42
Seconde lame quart d'onde 44
Lumière ambiante 46
Cellule d'affichage à cristal liquide réflective TN 60
Substrat avant 61
Substrat arrière 62
Cadre de scellement 63
Enceinte étanche 64
Electrodes transparentes 65a
Contre-électrodes transparentes 65b
Cellule d'affichage à cristal liquide réflective VA 600

## Revendications

1. Ensemble d'affichage pour un objet portable, cet ensemble d'affichage (1) comprenant un premier dispositif d'affichage émissif (2) au moins partiellement transparent, ce premier dispositif d'affichage émissif (2) comprenant une cellule d'affichage émissive transparente à diodes organiques électroluminescentes (20) ou une cellule d'affichage émissive transparente inorganique, un second dispositif d'affichage réflectif (6) et une cellule solaire (10) étant disposés dans cet ordre sous le premier dispositif d'affichage émissif (2), le second dispositif d'affichage réflectif (6) étant agencé pour commuter entre un état transparent dans lequel il n'affiche aucune information et un état réflectif lorsqu'il est activé, le second dispositif d'affichage réflectif (6) comprenant une cellule d'affichage à cristal liquide réflective (60), un polariseur absorbant (30) étant disposé sur une face supérieure de la cellule d'affichage à cristal liquide réflective (60), et un polariseur réflectif (34) étant disposé sous une face inférieure du substrat arrière (62) de la cellule d'affichage à cristal liquide réflective (60), un polariseur circulaire (38) qui se compose d'un second polariseur absorbant (40) et d'une première lame quart d'onde (42) étant placé au-dessus de la cellule d'affichage émissive transparente à diodes organiques électroluminescentes (20) ou au-dessus de la cellule d'affichage émissive transparente inorganique, et une seconde lame quart d'onde (44) étant placée sous la cellule d'affichage émissive transparente à diodes organiques électroluminescentes (20) ou sous la cellule d'affichage émissive transparente inorganique, la seconde lame quart d'onde (44) étant parallèle à la première lame quart d'onde (42) ou bien disposée à 90° par rapport à la première lame quart d'onde (42).

2. Ensemble d'affichage selon la revendication 1, **caractérisé en ce que** le dispositif d'affichage émissif (2) est collé sur le dispositif d'affichage réflectif (6).

3. Ensemble d'affichage selon la revendication 2, **caractérisé en ce que** le dispositif d'affichage émissif (2) est collé sur le dispositif d'affichage réflectif (6) au moyen d'un adhésif en film ou d'une couche de colle liquide.

4. Ensemble d'affichage selon l'une quelconque des revendications 1 à 3, **caractérisé en ce que** la cellule d'affichage émissive transparente à diodes organiques électroluminescentes (20) comprend un empilement de couches électroluminescentes (24) pris en sandwich entre une électrode supérieure transparente (25) et une électrode inférieure transparente (26).

5. Ensemble d'affichage selon l'une quelconque des revendications 1 à 4, **caractérisé en ce que** la cellule d'affichage à cristal liquide réflective (60) est choisie dans le groupe formé par les cellules à cristal liquide de type nématique en hélice, les cellules à cristal liquide de type super- nématique en hélice et les cellules d'affichage à cristal liquide à alignement vertical et **en ce que** l'adressage de ces cellules d'affichage à cristal liquide peut être de type direct, du type par matrice active ou du type adressage multiplexé d'une matrice passive.

6. Objet portable comprenant un ensemble d'affichage selon l'une quelconque des revendications précédentes.

7. Objet portable selon la revendication 6, **caractérisé en ce qu'**il s'agit d'une montre-bracelet.

## Patentansprüche

1. Anzeigeanordnung für einen tragbaren Gegenstand, wobei diese Anzeigeanordnung (1) eine erste emittierende Anzeigevorrichtung (2), die zumindest teilweise lichtdurchlässig ist, umfasst, wobei diese erste emittierende Anzeigevorrichtung (2) eine lichtdurchlässige emittierende Anzeigezelle mit organischen Elektrolumineszenzdioden (20) oder eine anorganische lichtdurchlässige emittierende Anzeigezelle aufweist, wobei eine zweite reflektierende Anzeigevorrichtung (6) und eine Solarzelle (10) in dieser Reihenfolge unter der ersten emittierenden Anzeigevorrichtung (2) angeordnet sind, wobei die zweite reflektierende Anzeigevorrichtung (6) dafür ausgelegt ist, zwischen einem lichtdurchlässigen Zustand, in der sie keinerlei Informationen anzeigt, und einem reflektierenden Zustand, wenn sie aktiviert ist, umzuschalten, wobei die zweite reflektierende Anzeigevorrichtung (6) eine reflektierende Flüssigkristallanzeigezelle (60) aufweist, wobei ein absorbierender Polarisator (30) auf einer oberen Fläche der reflektierenden Flüssigkristallanzeigezelle (60) angeordnet ist und wobei ein reflektierender Polarisator (34) unter einer unteren Fläche des hinteren Substrats (62) der reflektierenden Flüssigkristallanzeigezelle (60) angeordnet ist, wobei ein Zirkular-Polarisator (38), der aus einem zweiten absorbierenden Polarisator (40) und aus einem Lambda-Viertelplättchen (42) gebildet ist, über der lichtdurchlässigen emittierenden Anzeigezelle mit organischen Elektrolumineszenzdioden (20) oder über der anorganische lichtdurchlässige emittierende Anzeigezelle angeordnet ist und wobei ein zweites Lambda-Viertelplättchen (44) unter der lichtdurchlässigen emittierenden Anzeigezelle mit organischen Elektrolumineszenzdioden (20) oder unter der anorganische lichtdurchlässige emittierende Anzeigezelle angeordnet ist, wobei das zweite Lambda-Viertelplättchen (44) zu dem ersten Lambda-Viertelplättchen (42) parallel ist oder unter 90° in Bezug auf das erste Lambda-Viertelplättchen (42) angeordnet ist.

2. Anzeigeanordnung nach Anspruch 1, **dadurch gekennzeichnet, dass** die emittierende Anzeigevorrichtung (2) auf der reflektierenden Anzeigevorrichtung (6) geklebt ist.

3. Anzeigeanordnung nach Anspruch 2, **dadurch gekennzeichnet, dass** die emittierende Anzeigevorrichtung (2) auf der reflektierenden Anzeigevorrichtung (6) mittels eines Klebefilms oder einer Schicht aus flüssigem Klebstoff geklebt ist.

4. Anzeigeanordnung nach einem der Ansprüche 1 bis 3, **dadurch gekennzeichnet, dass** die lichtdurchlässige emittierende Anzeigezelle mit organischen Elektrolumineszenzdioden (20) einen Stapel elektrolumineszenter Schichten (24) umfasst, der zwischen einer lichtdurchlässigen oberen Elektrode (25) und einer lichtdurchlässigen unteren Elektrode (26) sandwichartig angeordnet ist.

5. Anzeigeanordnung nach einem der Ansprüche 1 bis 4, **dadurch gekennzeichnet, dass** die reflektierende Flüssigkristallanzeigezelle (60) aus der Gruppe gewählt ist, die gebildet ist aus Flüssigkristallzellen vom Twisted-Nematic Typ, Flüssigkristallzellen vom Super-Twisted Nematic Typ und Vertical-Alignment Flüssigkristallanzeigezellen, und dass die Adressierung dieser Flüssigkristallanzeigezellen vom direkten Typ, vom Typ mit Aktivmatrix oder vom Typ mit Multiplexadressierung einer Passivmatrix ist.

6. Tragbarer Gegenstand, umfassend eine Anzeigeanordnung nach einem der vorhergehenden Ansprüche.

7. Tragbarer Gegenstand nach Anspruch 6, **dadurch gekennzeichnet, dass** es sich um eine Armbanduhr handelt.

## Claims

1. Display assembly for a portable object, said display assembly (1) including a first, at least partially transparent, emissive display device (2) located on the side of an observer (4), said first emissive display device (2) including a transparent emissive organic light emitting diode display cell (20) or a transparent emissive inorganic display cell, a second reflective display device (6) and a solar cell (10) being arranged, in that order, underneath the first emissive display device (2), the second reflective display device (6) being capable of switching between a transparent state, in which the device does not display any information, and a reflective state, when activated, the second reflective display device (6) including a reflective liquid crystal display cell (60), an absorbent polarizer (30) being arranged on an upper face of the reflective liquid crystal display cell (60), and a reflective polarizer (34) being arranged underneath a lower face of the rear substrate (62) of the reflective liquid crystal display cell (60), a circular polarizer (38), which is formed of an absorbent polarizer (40) and a first quarter-wave plate (42), being placed above the transparent emissive organic light emitting diode display cell (20) or above the transparent emissive inorganic display cell, and a second quarter-wave plate (44) being placed underneath the transparent emissive organic light emitting diode display cell (20) or underneath the transparent emissive inorganic display cell, the second quarter-wave plate (44) being parallel to first quarter-wave plate (42) or arranged at 90° relative to first quarter-wave plate (42).

2. Display assembly according to claim 1, **characterized in that** the emissive display device (2) is bonded on the reflective display device (6).

3. Display assembly according to claim 2, **characterized in that** the emissive display device (2) is bonded on the reflective display device (6) by means of an adhesive film or a liquid adhesive layer.

4. Display assembly according to any of claims 1 to 3, **characterized in that** the transparent emissive organic light emitting diode display cell (20) includes a stack of electroluminescent layers (24) sandwiched between a transparent upper electrode (25) and a transparent lower electrode (26).

5. Display assembly according to any of claims 1 to 4, **characterized in that** the reflective liquid crystal display cell (60) is selected from the group comprising twisted nematic liquid crystal cells, super twisted nematic liquid crystal cells and vertically aligned liquid crystal display cells and **in that** the addressing of these liquid crystal display cells may be of the direct type, the active matrix type or the passive matrix multiplexing type.

6. Portable object including a display assembly according to any of the preceding claims.

7. Portable object according to claim 6, **characterized in that** the object is a wristwatch.
